# EUROPEAN PATENT SPECIFICATION

(11) **EP 4 402 491 B1**
(45) Date of publication and mention of the grant of the patent: **26.08.2026**
(21) Application number: 21801674.9
(22) Date of filing: 17.09.2021
(51) Int. Cl.: G01R 15/20, G01R 19/25, G01R 21/133

(54) **A POWER ANALYZER FOR MAINS SWITCHGEAR**
LEISTUNGSANALYSATOR FÜR NETZSCHALTANLAGE
ANALYSEUR DE PUISSANCE POUR APPAREILLAGE DE COMMUTATION AU RÉSEAU

(43) Date of publication of application: 24.07.2024
(73) Proprietor: Smarte Teknoloji Ve Enerji Sanayi Ticaret Anonim Sirketi, 34469 Sariyer/Istanbul (TR)
(72) Inventor: BALLIKAYA, Melih, 34467 Sariyer/Istanbul (TR); GUNAY, Selman, 34467 Sariyer/Istanbul (TR); CELIKKAYA, Recep, 34467 Sariyer/Istanbul (TR); SOTOUDEH, Naghi, 34467 Sariyer/Istanbul (TR)
(86) International application number: PCT/TR2021/050956
(87) International publication number: WO 2023/043389

(56) References cited:
- WO-A1-2020/049883
- DE-A1- 102013 106 216
- US-A1- 2021 088 557

## Description

### Technical Field of the Invention

The present invention relates to a power analyzer which is suitable to use on the mains switchgear.

### Background of the Invention

A power analyzer is the equipment which used to monitor the electrical parameters of the mains switchgear. Power analyzers can be used to measure the flow of energy in either alternating current (AC) or direct current (DC) systems. The power analyzer in the state of the art, the current value is determined by a current sensor. When the current value is determined by only one sensor, the measurement precision of the current value is decreased.

A prior art publication in the technical field of the invention may be referred to as EP3384576 (A1), which discloses a power analyzer.

DE 102013106216 A1 relates to a measuring device for current measurement in a control cabinet. Said measuring device comprises at least one current sensor and is designed as a comb rail into which the at least one current sensor is integrated. The document further disclosed a use of such a measuring device (10) in connection with a photovoltaic system which is designed to use its own energy.

WO 2020/049883 A1 discloses a non-clamp-form electric current measurement apparatus with which it is possible to measure a current in an electrical wire to be measured without clamping the electrical wire to be measured. The disclosed apparatus comprises a proximity sensor that acquires information pertaining to the distance from an electrical wire to be measured to a conductor, and a magnetism sensor that acquires information pertaining to a magnetic field produced due to a current flowing to the electrical wire to be measured. A measurement apparatus body comprises a CPU serving as a computation processing circuit that computes a current value flowing to the electrical wire to be measured from the information pertaining to a magnetic field as acquired by the magnetism sensor and the information pertaining to the distance from the electrical wire to be measured to the conductor as acquired by the proximity sensor.

US 2021/088557 A1 discloses a current measuring device includes two triaxial magnetic sensors that are arranged with a prescribed gap between the the two triaxial magnetic sensors such that magnetic-sensing directions of the two triaxial magnetic sensors are parallel to each other, and a calculator configured to calculate a current flowing in a measurement-object conductor based on detection results from the two triaxial magnetic sensors and a gap between the two triaxial magnetic sensors.

The invention provides an additional improvement to the prior art.

### Summary of the Invention

An object of the present invention is to determine the current value which flows in the cable of the mains switchgear in an accurate manner.

The present invention proposes a power analyzer for mains switchgear comprising, a main body, at least one housing which is formed on the main body, suitable for inserting the respective cable of the mains switchgear, a magnetic sensor provided on the main body for measuring a magnetic field value present in the housing when the respective cable of the mains switchgear is inserted into the housing. The power analyzer comprises a position sensor is provided on the main body for determining a distance value between the cable and the magnetic sensor and a control unit that is configured to calculate the current value which flows in the cable by using the distance value and the magnetic field value. A position sensor is a sensor that facilitates measurement of mechanical position. A position sensor may indicate absolute position (location) or relative position (displacement), in terms of linear travel, rotational angle, or three-dimensional space. The position sensor may be a capacitive displacement sensor or a differential capacitive sensor or an eddy current sensor or a laser sensor or a photodiode array or a hall effect sensor or an inductive sensor or an infrared sensor or a piezo-electric transducer or a position encoder or an ultrasound sensor or a RGB color space sensor or a time-of-flight sensor or an optical sensor or a camera or a stereo-camera or a lidar. The distance between the magnetic sensor and the outer surface of the cable can be determined by the position sensor. Since the magnetic sensor is fixed on the main body, the distance can be determined by the control unit after the cable position is determined by the position sensor. Moreover, detection of the presence or absence of the cable in the housing can be determined by means of the position sensor. The magnetic sensor may be an inductive sensor. In the preferred embodiment of the present invention, the magnetic sensor is a hall effect sensor. The magnetic sensor measures the value of the magnetic field which is created by the cable wherein the current flows. The control unit calculates the current value which flows in the cable by using the magnetic field value and the distance value. Since the distance between the outer surface of the cable and the magnetic sensor, and the value of the magnetic field which affects the magnetic sensor are determined in an accurate way, the current value can be calculated accurately by the control unit. The control unit is configured to calculate the current value continuously or periodically. Thus, the current value flowing in the cable is determined continuously.

In a possible embodiment, the power analyzer comprises the housing having two opposite side walls and a bottom wall. The housing is not surrounded by the walls in order to make it easier to be inserted cable into the housing. Besides, the cable is removed from the housing easily.

In a possible embodiment, the position sensor is an optical sensor. The optical sensor has a transmitter which is provided on the side wall and a receiver which provided on the opposite side wall to sense the light. More than one transmitter and receivers can be provided on the side walls in order to increase the measurement precision. Thus, cable position in the housing or the distance between the outer surface of the cable and the magnetic sensor is determined by the optical sensor precisely.

In a possible embodiment, the magnetic sensor is provided on the main body so as to be under the bottom wall of the housing. The magnetic sensor is fixed the under surface of the bottom wall so as to be in the main body. Thus, the distance value between the magnetic sensor and the outer surface of the cable equals to sum of the thickness value of the bottom wall and distance value between the outer surface of the cable within the housing and bottom wall. In this case, the distance between the bottom wall and the outer surface of the cable is determined by the position sensor. Then the control unit calculates the distance value between the outer surface of the cable and the magnetic sensor by adding the thickness value to the data which is collected by the position sensor. In a preferred embodiment of the present invention, the position sensor is calibrated by adding the thickness value to the data in order to determine the distance value between the outer surface of cable in the housing and magnetic sensor. Thus, the magnetic sensor is kept closer to the cable while the magnetic sensor is protected from being damaged by the environmental factors.

In a possible embodiment, at least one side wall is provided with a cable holder. The cable holder is made of an elastic material. Thus, the cable is fixed between the side walls while the outer surface of the cable is prevented from damaging.

In a possible embodiment, the main body comprises three housings. Thus, the power analyzer can be used on the three-phase type switchgears.

In a possible embodiment, the power analyzer comprises a wireless communication module. The wireless communication module can be a Wi-Fi or Bluetooth or any commercial radio communication type. The wireless communication module communicates with the mobile phone or computer. Thus, the user monitors the parameters of the power analyzer. Besides, the power analyzer is controlled remotely by the user.

In a possible embodiment, the power analyzer comprises a voltage sensing means which is adapted to collect a voltage signal from the mains switchgear for measuring the voltage value of the mains switchgear. Consumed electrical power value is calculated by multiplying the voltage value which is determined by the voltage sensing means and the current value which is calculated by the control unit. Thus, the quality of the voltage is determined. Besides, the power value is determined precisely.

In a possible embodiment, the power analyzer comprises at least three voltage sensing means which are connected to the main body. Three voltage sensing means are connected respective pins of the three-phase type switchgear. Thus, the power analyzer which can be used on the three-phase type switchgear is realized.

In a possible embodiment, the voltage sensing means are detachably attached each other. Thus, a compact block which is constructed by more than one voltage sensing means is realized.

In a possible embodiment, the voltage sensing means has an outer body which is provided with a protrusion and a corresponding recess, both of the protrusion and the recess are being sized and shaped to engage each other when the voltage sensing means are attached each other. Thus, the voltage sensing means are connected each other in a form-fit manner.

In a possible embodiment, the control unit is configured to generate a warning signal when the control unit determines that the position of the cable in the housing is changed. Thus, the user is informed about the cable position in the housing immediately.

In a possible embodiment, a display is used for displaying at least one parameter which is determined by the control unit. The display is provided on the main body. Thus, the user is informed about the parameters continuously.

### Brief description of the figures

The accompanying drawings are given solely for the purpose of exemplifying the invention whose advantages over prior art were outlined above and will be explained in detail hereinafter:

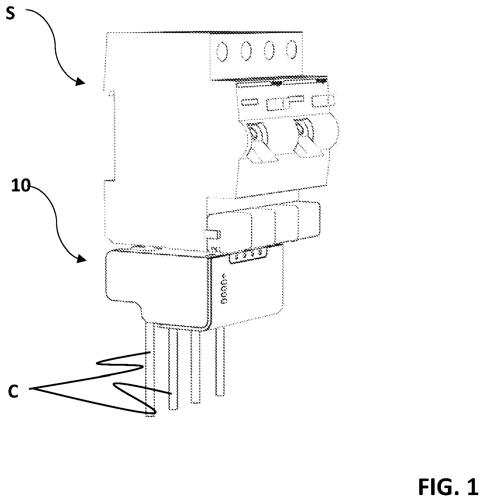

Fig. 1 is a perspective view of the power analyzer when the power analyzer is connected to the mains switchgear.
Fig. 2 is a perspective view of the power analyzer.
Fig. 3 is a schematic view of the power analyzer.
Fig. 4 is a schematic view of the power analyzer having two cable holders.
Fig. 5 is a schematic view of the power analyzer with four voltage sensing means.
Fig. 6 is a schematic view of the power analyzer with four voltage sensing means.

### Detailed description of the figures

The present invention proposes a power analyzer (10) for mains switchgear (S) comprising, a main body (20), at least one housing (21) which is formed on the main body (20), suitable for inserting the respective cable (C) of the mains switchgear (S), a magnetic sensor (30) provided on the main body (20) for measuring a magnetic field value present in the housing (21) when the respective cable (C) of the mains switchgear (S) is inserted into the housing (21). When a current flows in a cable (C), it creates a circular magnetic field around the cable (C). The magnetic sensor (30) measures the magnetic field value. The power analyzer (10) also comprises a position sensor (40) is provided on the main body (20) for determining a distance value between the cable (C) and the magnetic sensor (30) and a control unit (50) that is configured to calculate the current value which flows in the cable (C) by using the distance value and the magnetic field value. The strength of the magnetic field is greater closer to the cable (C), and increases if the current increases. The magnetic field value of the position at a distance of "r" from the outside surface of the cable (C) wherein the current flows is calculated by the formula which is given in Equation 1. $B = \frac{{μ}_{0} I}{2 πr}$

In Equation 1; "I" corresponds to current value in Amperes (A), "B" corresponds to magnetic field value in Tesla (T) and "r" corresponds to the distance from the outer surface of the cable in meters (m). *µ*₀ refers to the permeability of free space. *µ*₀ is a constant value and equals to 4*π*10⁻⁷*T. m*/*A* . As can be deducted from the Equation 1, the distance between the cable (C) and the magnetic sensor (30) is crucial for determining the magnetic field value accurately. The position sensor (40) is used for determining the cable (C) position in the housing (21) and/or determining distance between the cable (C) and the magnetic sensor (30). The position sensor (40) can also determine the diameter of the cable (C) which is positioned in the housing (21). Besides, position changes of the cable (C) in the housing (21) can be detected by means of the position sensor (40). When the cable (C) position is changed within the housing (21), the magnetic field value determined by the magnetic sensor (30) is changed. The control unit (50) is adapted to calculate the current value flowing in the cable (C) by using the magnetic field value and the distance between cable (C) and the magnetic sensor (30). In the preferred embodiment of the present invention, the control unit (50) is configured to calculate the current value as in Equation 1. Thus, the current value which flows in the cable (C) is determined accurately even if the cable (C) position is changed within the housing (21).

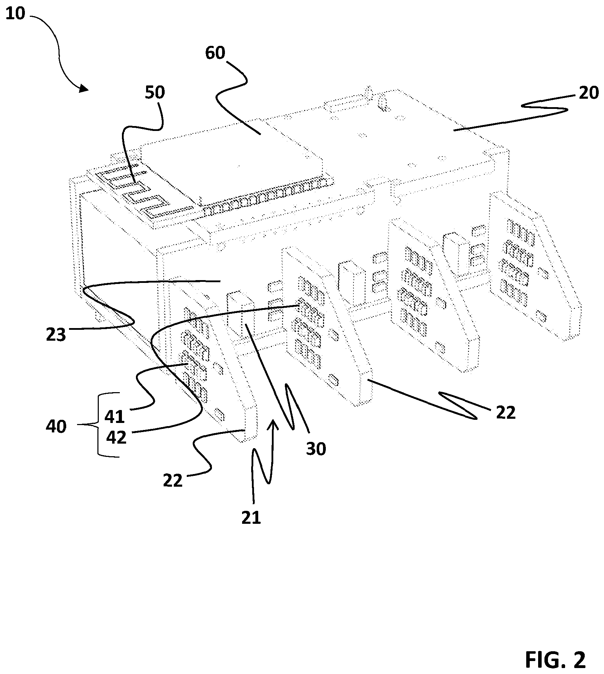

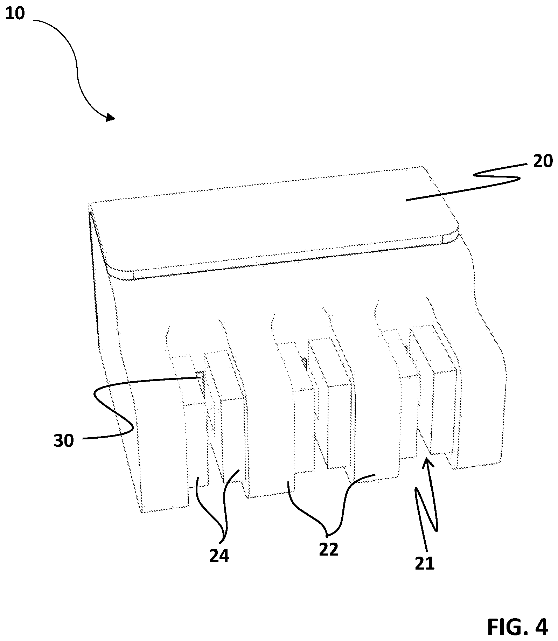

In an embodiment of the present invention, the housing (21) has two opposite side walls (22) and a bottom wall (23). As can be seen in the Fig. 2-4, the housing (21) is in the form of U-shaped. At least one portion of the cable (C) is inserted into the housing (21) so as to be between the side walls (22). Thus, the power analyzer (10) is attached to the cable (C) of the mains switchgear (S) easily.

In an embodiment of the present invention, the position sensor (40) is an optical sensor. Optical sensors operate using one of two principles. In the first type, the emitted light signal is reflected from the object being monitored returned towards the light source. A change in the light characteristics (e.g. wavelength, intensity, phase, polarization) is used to establish information about the object's position. Thus, the position of the cable (C) in the housing (21) is determined by using the data which is collected from the optical sensor.

In the second type, light is transmitted from a transmitter (41) and sent over to a receiver (42) at the other end of the optical sensor. Referring to Fig. 2, the transmitter (41) is provided on the side wall (22) and the receiver (42) is provided on the opposite side wall (22) to sense the light. When at least one portion of the cable (C) is inserted into the housing (21) so as to be between the side walls (22), some lights transmitted from the transmitter (41) are not received by the receiver (42). Thus, the position and the diameter of the cable (C) is determined in an accurate manner.

Referring to Fig. 2-4, the magnetic sensor (30) is provided on the bottom wall (23) of the housing (21). The magnetic sensor (30) is placed on the bottom wall (23) so as to be flush with the upper surface of the bottom wall (23), which faces the housing (21). In this construction, a sensor housing is provided on the bottom wall (23) and the magnetic sensor (30) is placed in the sensor housing. Therefore, the distance between the bottom wall (23) and the outer surface of the cable (C) equals to the distance between the magnetic sensor (30) and the outer surface of the cable (C). Thus, determining the current value is made easier and the precision of the calculation is increased.

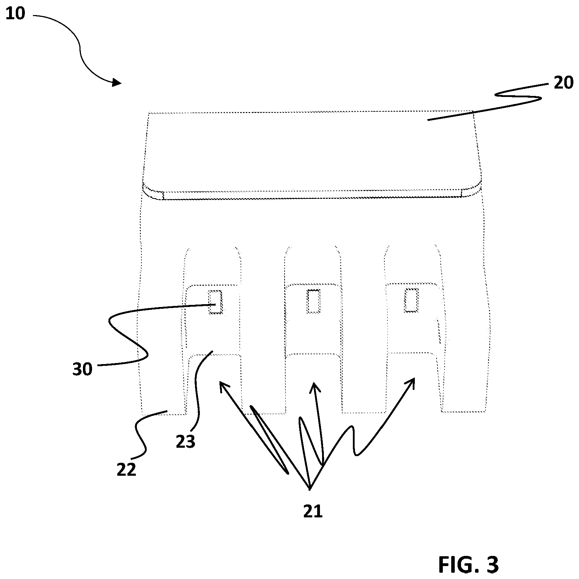

In an embodiment of the present invention, at least one side wall (22) is provided with a cable holder (24). As can be seen in Fig. 3, the cable (C) is connected to the side wall (22) by means of the cable holder (24). The cable (C) is removably connected to the cable holder (24). In the preferred embodiment of the invention disclosure, each side walls (22) are provided with a cable holder (24). The cable (C) is squeezed by the cable holders (24). Thus, the cable (C) is protected from moving unintentionally.

In another embodiment of the present invention, the main body (20) comprises three housings (21). The mains switchgear (S) may be a three-phase type. Therefore, respective cables (C) for each phase of the mains switchgear (S) are inserted into the respective housings (21). Thus, the power analyzer (10) can be used for determining the current values of three-phase type mains switchgear (S). These housings (21) are formed on the main body (20) side by side.

In another embodiment of the present invention, a wireless communication module (60) is provided on the main body (20). The wireless communication module (60) may be provided on the control unit (50). Thus, the power analyzer (10) transmits the data which is collected by the magnetic sensor (30) and/or position sensor (40) and/or calculated by the control unit (50) to the outside management or data storage device.

In another embodiment of the present invention, the power analyzer (10) comprises a voltage sensing means (70) which is adapted to collect a voltage signal from the mains switchgear (S) for measuring the voltage value of the mains switchgear (S) and the control unit (50) is adapted to calculate power value by multiplying the voltage value and the current value. The voltage sensing means (70) is connected to the main body (20) of the power analyzer (10) via a conductor. Voltage sensing means (70) has at least one voltage probe (74) which is suitable to insert respective pins of the mains switchgear (S). In the preferred embodiment of the present invention, the voltage sensing probe (74) is provided with a magnetic material in order to connect the voltage sensing probe (74) and the respective pins of the mains switchgear (S). Voltage sensing means (70) is attached to the respective pins of the mains switchgear (S). The control unit (50) is adapted to calculate the power value by using the current value which is calculated by the control unit (50) and the voltage value which is measured by the voltage sensing means (70). The power value is the rate, per unit time, at which electrical energy is transferred by an electric circuit. For any circuit element, the power value is equal to the voltage difference across the element multiplied by the current value. Thus, the power value is determined by the power analyzer (10). The power value is calculated in terms of Watt.

In another embodiment of the present invention, at least three voltage sensing means (70) are connected to the main body (20). Thus, the power analyzer (10) can be used in three-phase type mains switchgear (S). In the preferred embodiment of the present invention, four voltage sensing means (70) are used for determining the voltage value of the mains switchgear (S). Three of these voltage sensing means (70) are used for the three-phase and the fourth voltage sensing means (70) is used for grounding.

In an embodiment of the present invention, the voltage sensing means (70) are detachably attached each other. The cable (C) layout of the mains switchgear (S) is not the same for every mains switchgear (S). Since the voltage sensing means (70) are detachably attached each other, the layout of the voltage sensing means (70) can be arranged for being used on the mains switchgears (S) having different cable (C) layout.

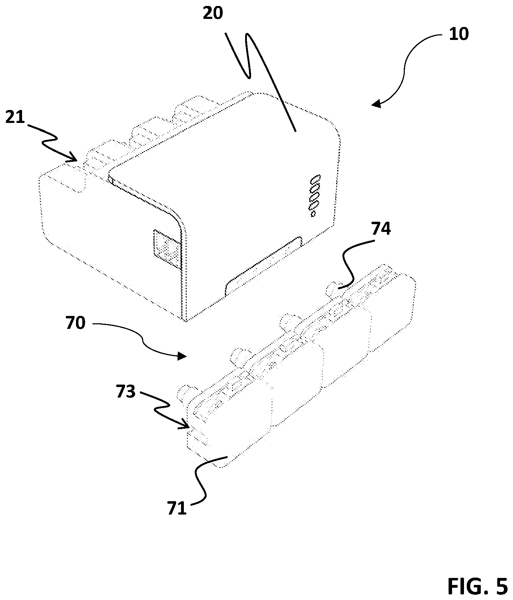

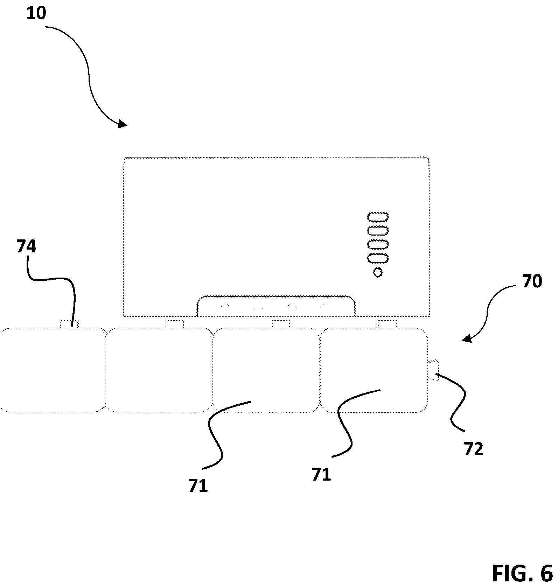

Referring to Fig. 5 and 6, the voltage sensing means (70) has an outer body (71) which is provided with a protrusion (72) and a corresponding recess (73), both of the protrusion (72) and the recess (73) are being sized and shaped to engage each other when the voltage sensing means (70) are attached each other. In the preferred embodiment of the present invention, each outer body (71) of the voltage sensing means are same. As can be seen in Fig. 5, the outer body (71) is provided with a recess (73) on the left side of the outer body (71). As can be seen in Fig. 6, the outer body (71) is provided with a protrusion (72) on the right side of the outer body (71). Thus, these two voltage sensing means (70) can be connected to each other side by side by means of the protrusion (72) and the recess (73). When the user wants to change the position of the voltage sensing means (70) with respect to each other, the user separates the protrusion (72) of the first voltage sensing means (70) from the recess (73) of the second voltage sensing means (70) and the user inserts the protrusion (72) of the second voltage sensing means (70) into the recess (73) of the first voltage sensing means (73). Thus, the voltage sensing means (70) are connected each other in a form-fit manner.

In another embodiment of the present invention, the control unit (50) is configured to generate a warning signal when the control unit (50) determines that the position of the cable (C) in the housing (21) is changed. The warning signal can be an audio warning or a visual warning. The control unit (50) determines that the position of the cable (C) in the housing (21) according to the data which is obtained by the position sensor (40). When the position of the cable (C) in the housing (21) is changed, the control unit (50) generates a warning signal for the user. Thus, the user recognizes the changing position of the cable (C) in the housing (21). Moreover, another warning signal can be generated for the user if the control unit (50) detects the absence of the cable (C) in the housing (21). Absence of the cable (C) can be determined by the position sensor (40) or magnetic sensor (30).

In another embodiment of the present invention, a display is used for displaying at least one parameter which is determined by the control unit (50). The display is electrically connected to the power analyzer (10). Thus, monitoring of the parameters is made easier.

### Reference numbers:

- 10.: Power analyzer
- 20.: Main body
21. Housing
22. Side wall
23. Bottom wall
24. Cable holder
- 30.: Magnetic sensor
- 40.: Position sensor
41. Transmitter
42. Receiver
- 50.: Control unit
- 60.: Wireless communication module
- 70.: Voltage sensing means
71. Outer body
72. Protrusion
73. Recess
74. Voltage sensing probe

## Claims

1. A power analyzer (10) for mains switchgear (S) comprising,
- a main body (20),
- at least one housing (21) which is formed on the main body (20), suitable for inserting the respective cable (C) of the mains switchgear (S),
- a magnetic sensor (30) provided on the main body (20) configured for measuring a magnetic field value present in the housing (21) when the respective cable (C) of the mains switchgear (S) is inserted into the housing (21) **characterized in that**
- a position sensor (40) is provided on the main body (20) configured for determining a distance value between the cable (C) and the magnetic sensor (30) and
- a control unit (50) that is configured to calculate the current value which flows in the cable (C) by using the distance value and the magnetic field value.

2. The power analyzer (10) according to Claim 1, wherein the housing (21) has two opposite side walls (22) and a bottom wall (23).

3. The power analyzer (10) according to Claim 1 or 2, wherein the position sensor (40) is an optical sensor.

4. The power analyzer (10) according to Claim 3, wherein the optical sensor has a transmitter (41) which is provided on the side wall (22) and a receiver (42) which is provided on the opposite side wall (22) to sense the light.

5. The power analyzer (10) according to Claim 2 - 4, wherein the magnetic sensor (30) is provided on the bottom wall (23) of the housing (20).

6. The power analyzer (10) according to Claim 2 - 5, wherein at least one side wall (22) is provided with a cable holder (24).

7. The power analyzer (10) according to any of the preceding claims, wherein the main body (20) comprises three housings (21).

8. The power analyzer (10) according to any of the preceding claims, wherein a wireless communication module (60) is provided on the main body (20).

9. The power analyzer (10) according to any of the preceding claims, wherein a voltage sensing means (70) is adapted to collect a voltage signal from the mains switchgear (S) for measuring the voltage value of the mains switchgear (S) and the control unit (50) is adapted to calculate power value by multiplying the voltage value and the current value.

10. The power analyzer (10) according to Claim 9, wherein at least three voltage sensing means (70) are connected to the main body (20).

11. The power analyzer (10) according to Claim 9 or 10, wherein the voltage sensing means (70) are detachably attached each other.

12. The power analyzer (10) according to Claim 11, wherein the voltage sensing means (70) has an outer body (71) which is provided with a protrusion (72) and a corresponding recess (73), both of the protrusion (72) and the recess (73) are being sized and shaped to engage each other when the voltage sensing means (70) are attached each other.

13. The power analyzer (10) according to any of the preceding claims, wherein the control unit (50) is configured to generate a warning signal when the control unit (50) determines that the position of the cable (C) in the housing (21) is changed.

14. The power analyzer (10) according to any of the preceding claims, wherein a display is used for displaying at least one parameter which is determined by the control unit (50).

## Patentansprüche

1. Leistungsanalysator (10) für eine Netzschaltanlage (S), umfassend
- einen Hauptkörper (20),
- wenigstens ein am Hauptkörper (20) ausgebildetes Gehäuse (21), das zur Aufnahme des jeweiligen Kabels (C) der Netzschaltanlage (S) geeignet ist,
- einen am Hauptkörper (20) vorgesehenen magnetischen Sensor (30), der dazu eingerichtet ist, einen im Gehäuse (21) vorhandenen magnetischen Feldwert zu messen, wenn das jeweilige Kabel (C) der Netzschaltanlage (S) in das Gehäuse (21) eingesetzt ist,
**dadurch gekennzeichnet, dass**
- ein am Hauptkörper (20) vorgesehener Positionssensor (40) dazu eingerichtet ist, einen Abstandswert zwischen dem Kabel (C) und dem magnetischen Sensor (30) zu bestimmen, und
- eine Steuereinheit (50), die dazu eingerichtet ist, den durch das Kabel (C) fließenden Stromwert unter Verwendung des Abstandswerts und des magnetischen Feldwerts zu berechnen.

2. Leistungsanalysator (10) nach Anspruch 1, wobei das Gehäuse (21) zwei einander gegenüberliegende Seitenwände (22) und eine Bodenwand (23) aufweist.

3. Leistungsanalysator (10) nach Anspruch 1 oder 2, wobei der Positionssensor (40) ein optischer Sensor ist.

4. Leistungsanalysator (10) nach Anspruch 3, wobei der optische Sensor einen Sender (41) aufweist, der an der Seitenwand (22) vorgesehen ist, und einen Empfänger (42), der an der gegenüberliegenden Seitenwand (22) vorgesehen ist, um Licht zu detektieren.

5. Leistungsanalysator (10) nach einem der Ansprüche 2 bis 4, wobei der magnetische Sensor (30) an der Bodenwand (23) des Gehäuses (21) vorgesehen ist.

6. Leistungsanalysator (10) nach einem der Ansprüche 2 bis 5, wobei wenigstens eine Seitenwand (22) mit einer Kabelhalterung (24) versehen ist.

7. Leistungsanalysator (10) nach einem der vorhergehenden Ansprüche, wobei der Hauptkörper (20) drei Gehäuse (21) umfasst.

8. Leistungsanalysator (10) nach einem der vorhergehenden Ansprüche, wobei ein drahtloses Kommunikationsmodul (60) am Hauptkörper (20) vorgesehen ist.

9. Leistungsanalysator (10) nach einem der vorhergehenden Ansprüche, wobei eine Spannungserfassungseinrichtung (70) dazu eingerichtet ist, ein Spannungssignal von der Netzschaltanlage (S) zu erfassen, um den Spannungswert der Netzschaltanlage (S) zu messen, und die Steuereinheit (50) dazu eingerichtet ist, einen Leistungswert durch Multiplikation des Spannungswerts mit dem Stromwert zu berechnen.

10. Leistungsanalysator (10) nach Anspruch 9, wobei wenigstens drei Spannungserfassungseinrichtungen (70) mit dem Hauptkörper (20) verbunden sind.

11. Leistungsanalysator (10) nach Anspruch 9 oder 10, wobei die Spannungserfassungseinrichtungen (70) lösbar miteinander verbunden sind.

12. Leistungsanalysator (10) nach Anspruch 11, wobei die Spannungserfassungseinrichtung (70) einen äußeren Körper (71) aufweist, der mit einem Vorsprung (72) und einer entsprechenden Ausnehmung (73) versehen ist, wobei der Vorsprung (72) und die Ausnehmung (73) so dimensioniert und geformt sind, dass sie beim Verbinden der Spannungserfassungseinrichtungen (70) miteinander ineinandergreifen.

13. Leistungsanalysator (10) nach einem der vorhergehenden Ansprüche, wobei die Steuereinheit (50) dazu eingerichtet ist, ein Warnsignal zu erzeugen, wenn die Steuereinheit (50) bestimmt, dass sich die Position des Kabels (C) im Gehäuse (21) geändert hat.

14. Leistungsanalysator (10) nach einem der vorhergehenden Ansprüche, wobei eine Anzeige verwendet wird, um wenigstens einen von der Steuereinheit (50) bestimmten Parameter anzuzeigen.

## Revendications

1. Analyseur de puissance (10) pour un appareillage de commutation électrique (S) comprenant :
- un corps principal (20),
- au moins un logement (21) formé sur le corps principal (20), apte à recevoir le câble respectif (C) de l'appareillage de commutation électrique (S),
- un capteur magnétique (30) disposé sur le corps principal (20), configuré pour mesurer une valeur de champ magnétique présente dans le logement (21) lorsque le câble respectif (C) de l'appareillage de commutation électrique (S) est inséré dans le logement (21),
**caractérisé en ce que**
- un capteur de position (40) est disposé sur le corps principal (20), configuré pour déterminer une valeur de distance entre le câble (C) et le capteur magnétique (30), et
- une unité de commande (50) configurée pour calculer la valeur du courant circulant dans le câble (C) en utilisant la valeur de distance et la valeur du champ magnétique.

2. Analyseur de puissance (10) selon la revendication 1, dans lequel le logement (21) comprend deux parois latérales opposées (22) et une paroi de fond (23).

3. Analyseur de puissance (10) selon la revendication 1 ou 2, dans lequel le capteur de position (40) est un capteur optique.

4. Analyseur de puissance (10) selon la revendication 3, dans lequel le capteur optique comprend un émetteur (41) disposé sur une paroi latérale (22) et un récepteur (42) disposé sur la paroi latérale opposée (22) afin de détecter la lumière.

5. Analyseur de puissance (10) selon l'une quelconque des revendications 2 à 4, dans lequel le capteur magnétique (30) est disposé sur la paroi de fond (23) du logement (21).

6. Analyseur de puissance (10) selon l'une quelconque des revendications 2 à 5, dans lequel au moins une paroi latérale (22) est pourvue d'un support de câble (24).

7. Analyseur de puissance (10) selon l'une quelconque des revendications précédentes, dans lequel le corps principal (20) comprend trois logements (21).

8. Analyseur de puissance (10) selon l'une quelconque des revendications précédentes, dans lequel un module de communication sans fil (60) est disposé sur le corps principal (20).

9. Analyseur de puissance (10) selon l'une quelconque des revendications précédentes, dans lequel un moyen de détection de tension (70) est adapté pour collecter un signal de tension provenant de l'appareillage de commutation électrique (S) afin de mesurer la valeur de tension de l'appareillage de commutation électrique (S), et l'unité de commande (50) est adaptée pour calculer une valeur de puissance en multipliant la valeur de tension et la valeur de courant.

10. Analyseur de puissance (10) selon la revendication 9, dans lequel au moins trois moyens de détection de tension (70) sont connectés au corps principal (20).

11. Analyseur de puissance (10) selon la revendication 9 ou 10, dans lequel les moyens de détection de tension (70) sont attachés de manière amovible les uns aux autres.

12. Analyseur de puissance (10) selon la revendication 11, dans lequel le moyen de détection de tension (70) comprend un corps externe (71) pourvu d'une saillie (72) et d'un évidement correspondant (73), la saillie (72) et l'évidement (73) étant dimensionnés et façonnés de manière à s'engager l'un dans l'autre lorsque les moyens de détection de tension (70) sont attachés les uns aux autres.

13. Analyseur de puissance (10) selon l'une quelconque des revendications précédentes, dans lequel l'unité de commande (50) est configurée pour générer un signal d'avertissement lorsque l'unité de commande (50) détermine que la position du câble (C) dans le logement (21) a changé.

14. Analyseur de puissance (10) selon l'une quelconque des revendications précédentes, dans lequel un affichage est utilisé pour afficher au moins un paramètre déterminé par l'unité de commande (50).
